Europäisches Patentamt

European Patent Office

Office européen des brevets

(19)

(11) Publication number: **0 039 122**

**A2**

(12)

# EUROPEAN PATENT APPLICATION

(21) Application number: **81300699.6**

(22) Date of filing: **19.02.81**

(51) Int. Cl.³: **G 01 R 31/02**

(30) Priority: **04.03.80 GB 8007338**

(43) Date of publication of application:
**04.11.81 Bulletin 81/44**

(84) Designated Contracting States:
**BE DE FR GB IT NL SE**

(71) Applicant: THOMAS ELECTRONICS LIMITED
Garrison Works Birch Vale
Stockport Cheshire(GB)

(71) Applicant: E.R.F. LIMITED
Sun Works
Sandbach Cheshire(GB)

(72) Inventor: George, Leslie Edward
64 Grange Park Avenue Chapel-en-le-Frith
Stockport Cheshire(GB)

(72) Inventor: Payne, George Vernon
"Crowthorne"219 Crew Road
Sandbach Cheshire(GB)

(74) Representative: Paget, Hugh Charles Edward et al,
MEWBURN ELLIS & CO. 70.72 Chancery Lane
London WC2A 1AD(GB)

(54) Apparatus and method for testing electrical systems of a vehicle.

(57) An apparatus for testing electrical systems of vehicles has a plurality of test circuits (12,14,16) arranged in parallel across a power supply. A selection switch (18,20,22) is associated with each of the test circuits (12,14,16) and each selection switch allows various items of the electrical system of the vehicle to be connected to the associated test circuit. A master switch 10 operates to connect only one of the circuits (12,14,16) to the power supply at any one time so that only one item of the electrical system of the vehicle may be tested at any one time. The apparatus may be operated manually or may be connected to a control device which allows automatic selection of the item to be tested. In carrying out the testing method, the apparatus is connected to the vehicle and the switches are operated so that tests are performed on different items of the electrical system of the vehicle selectively.

Fig.1.

"An apparatus and a method for testing electrical systems of a vehicle, and the combination of a vehicle and such an apparatus". TITLE MODIFIED see front page

The present invention relates to an apparatus and a method of testing electrical systems of a vehicle and the combination of a vehicle and such an apparatus, for example, for testing the integrity of the electrical wiring, the lights, direction indicators, alternator, and the like.

Fault finding in the electrical systems of motor vehicles has previously involved many hours of work, partly because a malfunction in a particular item of equipment may very often be due to a fault in any one of several component parts or in any one of several runs of wiring, and partly because access to such component parts and runs of wiring may be difficult so that the necessary test to isolate the particular fault although relatively simple and straightforward in theory may be laborious and difficult in practice. The present invention seeks to provide an apparatus and a method whereby such tests can be carried out with greater facility than hitherto.

Broadly the present invention achieves this by providing an apparatus with a number of different test circuits which are connected together and to connection leads adapted to be connected to the electrical systems of the vehicle so that only one electrical system may be tested at any one time.

This is achieved by switch means associated with the test circuits which selects the electrical system and the appropriate test circuit. Testing is then carried out by comparison of a property of that electrical system with a reference signal established in the chosen test circuit. Preferably the switch means includes a master switch adapted selectively to energise one only of the test circuits to establish said reference signal in it.

It is possible that only one connection lead is associated with each test circuit. However, most vehicles have a number of systems capable of being tested by the same test circuit and therefore, to save effort and to reduce the number of test circuits required, a plurality of connection leads may be associated with each of the test circuits, and the switch means includes a selection switch associated with each of the test circuits each selection switch being adapted to selectively connect one only of the leads to its associated test circuit.

The state of the part of the system under test will preferably be indicated by/three test lamps. The arrangement will preferably be such that the systems to be checked can be divided into six main groups as follows:-

1.          Battery feeds.

2.          Battery returns.

3.          Instruments, and gauges.

4.          Solenoids and inductive loads.

5.          Motors.

6.          Lighting.

The testing apparatus may be connected to an automatic or semi-automatic control device, which allows automatic selection of the circuit to be tested (with or without manual over-ride). Such a control device may test each circuit in turn, until a defective circuit is found. It may then provide for display of relevant information about the defective circuit, or, if the control device is provided with a suitable memory, indicate the steps necessary to repair the fault. Such a control device ensures that every relevant circuit has been tested, and performs all the tests in a shorter time than would be possible with manual selection of the test circuitry.

A vehicle to be tested may be provided with sockets, each connected to one of the electrical systems of the vehicle. These sockets may then be connected to the connection leads of the test apparatus.

The present invention also provides the combination of a vehicle and an apparatus for testing electrical systems of the vehicle, the vehicle being provided with electrical sockets connected to respective testing points in the electrical systems of the vehicle, the apparatus comprising a plurality of electrical connectors each of which is connected to one of the sockets, a plurality of test circuits at least two of said connectors being associated with each test circuit, a selection switch associated with each test circuit for selectively connecting one only of the connectors to its respective test circuit, and a master switch for selecting one only of/said electrical systems may be tested at any one time the test circuits so that one only of by comparison of a property of that electrical system with a reference signal established in the selected test circuit.

In order that the invention may be fully understood and readily carried into effect, the same will now be described, by way of example only, with reference to the accompanying drawings, of which:-

Fig. 1 is a diagrammatic illustration of a testing apparatus embodying the invention connected to a vehicle provided with suitable electrical sockets, and

Fig. 2 shows, in diagrammatic form, the connection of a testing apparatus according to the present invention to a control device and further systems; and

Figs. 3 to 12 are individual electrical measurement circuits provided within the apparatus and capable of being selected for making various tests.

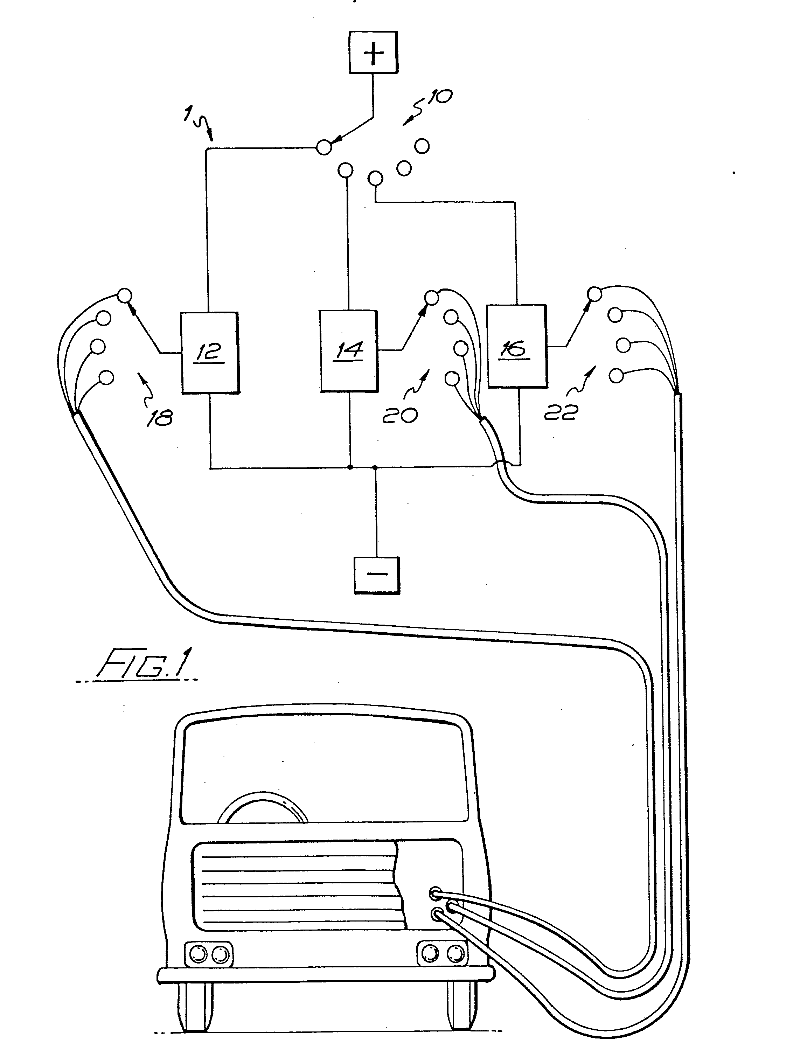

Referring now to Fig. 1 of the drawings, the testing apparatus 1 there illustrated includes a master selection switch 10 connectable to a plurality of measurement circuits selectively, three such measurement circuits being indicated 12, 14 and 16. Selection switches 18, 20 and 22 allow various items of the electrical system capable of being tested to be selected for testing. Testing is only possible at any one time on the selected measurement circuit and only one test may be carried out at any one time. Electric leads from the measurement circuits are shown to be connected to multi-pin connectors which can be plugged into respective electric sockets provided on the vehicle to be tested, the leads from said electric sockets being connected to respective testing points in the electrical systems of the vehicle.

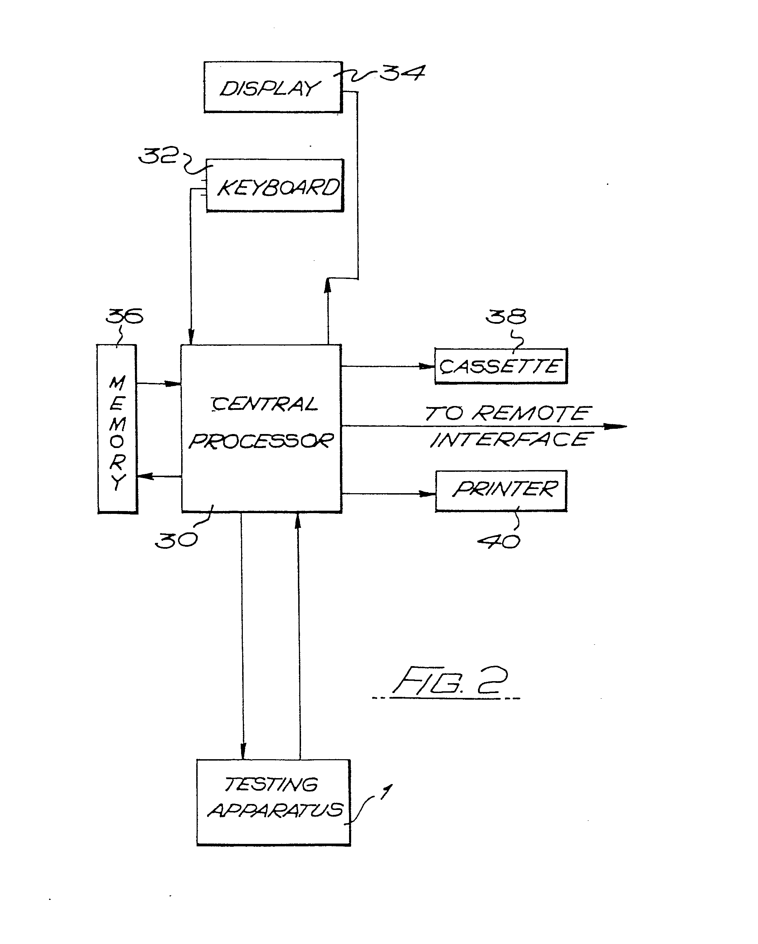

Fig. 2 shows a control device for automatic testing connected to the testing apparatus of Fig. 1. In such an arrangement the selection switches are electronically controlled by the control device. As illustrated, the control device has a central processor 20 connected to the testing apparatus 1. On instruction from an operator controlled keyboard 32, the central processor 30 controls the switching of the circuits of the testing apparatus 1 to activate each of the testing circuits 12, 14, 16 (Fig. 1) in a predetermined sequence.

When one of the systems under test is found to be faulty, the display 34 then displays information about the failed circuit and instructs the operator to take any relevant action e.g. operating one of the systems in the vehicle under test. Information relating to diagnosis of the fault is recalled from a memory 36 and a suitable course of action diaplayed on the display 34. In addition, a tape recorder 38 may be activated to give an audible diagnosis.

The display 34 may comprise or include a CRT display indicating a test index. The keyboard 32 may then allow the operator to over-ride the automatic test sequence and select one test only, or to delete one or more tests from the sequence.

The information thus obtained may be fed to a printer 40 or to some other remote interface (not shown). In this way a permanent record of the tests made could be produced.

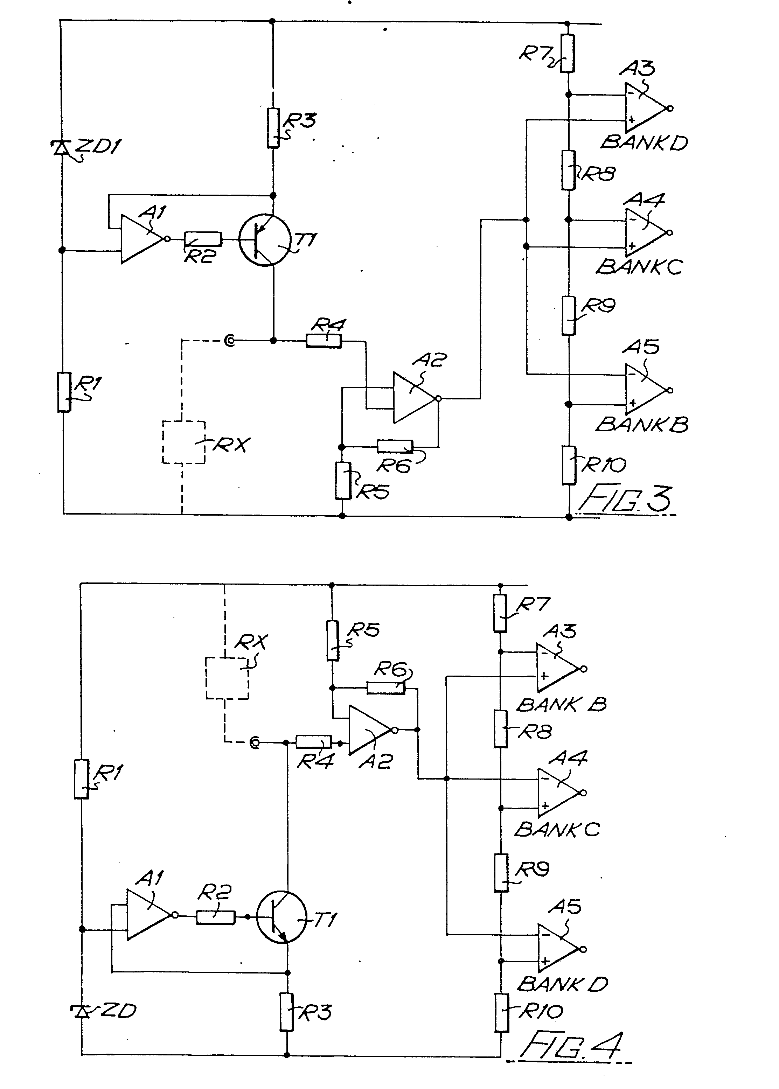

Referring now to Fig. 3, this shows a general arrangement for checking the quality of a cable and any connections contained therein when only one end is directly accessible the other tied to the main - ve bus.

A zener diode ZD1 and a resistor R1 are connected in series across a voltage supply. The reference voltage generated at the junctions between the zener diode ZD1 and the resistor R1 is fed to the non-inverting input of an amplifier A1. The output of the amplifier A1 is connected with a resistor R2 to the base electrode of a transistor T1. The emitter electrode of the transistor T1 is connected to the inverting input of amplifier A1 and also to the positive bus via a resistor R3. The collector electrode of transistor T1 is connected to the input which is to be connected to the cable Rx under test. The amplifier A1 and the transistor T1 form current amplifiers and are independent of voltage fluctuations within a given range of voltage. The resistor R3 limits the current passed by the transistor T1 in the event that its collector electrode is connected directly to the negative bus, and thereby preventing damage to the transistor T1.

When the cable R1 is connected between the negative bus and the collector electrode of the transistor T1, a current will flow through the series circuit formed by resistor R3, transistor T1 and the cable Rx. The magnitude of this current, and hence the potential at the collector electrode of transistor T1, is determined by the quality of the cable Tx and the resistance of transistor T1. The collector electrode of transistor T1 is connected via resistor R4 to the non-inverting input of an amplifier A2, the inverting input of which is connected to the negative bus via resistor R5. Hence the difference between the potential at the collector electrode of transistor T1 and the potential across resistor R5 is amplified. The resistance of resistor R5 may be set so that a "good" cable will produce a zero output from amplifier A2.

A voltage divider is formed by resistors R7 to R10 connected in series and the junctions of the resistors are connected respectively to the inverting input of amplifiers A3 and A5 and the non-inverting input of amplifier A5. The non-inverting inputs of amplifiers A3 and A4 and the inverting input of amplifier A5 are each connected to the output of amplifier A2, which is also connected to its inverting input by feedback resistor R6.

The voltages at the junctions of resistors R7 to R10 are such that, should the amplifier produce an output corresponding to a 'good' cable, the output of amplifier A5 will be high whilst the outputs of amplifiers A3 and A4 will be low.

Should the resistance of the cable RX be such that it is higher than normal, but not too high, then the output from amplifier A2 will cause amplifier A4 to produce a high output to indicate a 'poor' cable. If the resistance of the cable RX is even higher then the output of amplifier A3 is high.

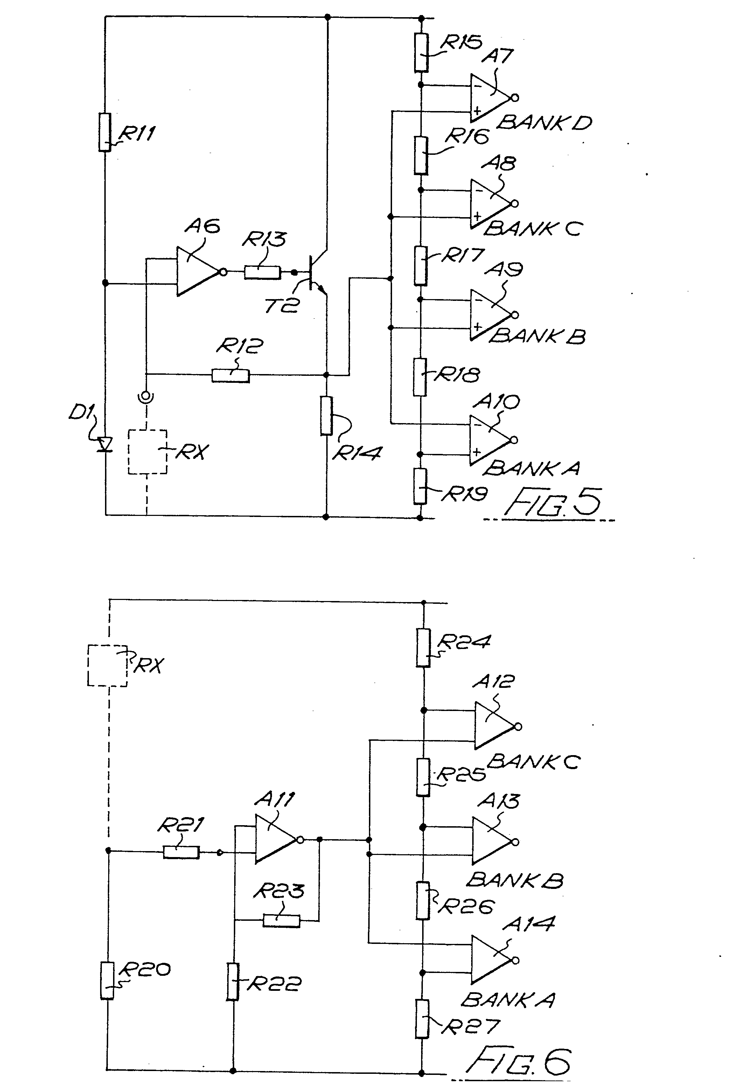

For a cable connected to the positive bus, the circuit of Fig. 4 is used. This circuit is similar to that of Fig. 3 but is inverted relative to the power buses. Its operation is the same as the circuit shown in Fig. 4 and the same reference numerals are used.

If the circuit to be tested is e. g. the solenoid, it is important that only a very low current flows through the cable under test. This is necessary in the case of a solenoid since it is important that the solenoid does not become energised under test as this would be dangerous for the operator.

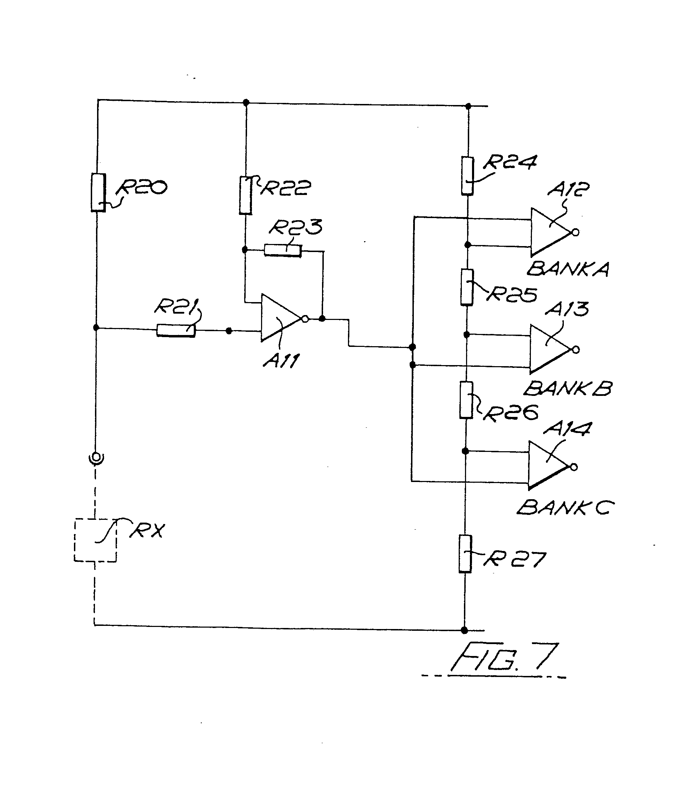

Fig. 5 shows a circuit arrangement suitable for testing a solenoid. The cable RX under test is connected directly between the negative bus and the inverting input of an amplifier A6. The non-inverting input of amplifier A6 is connected to the junction between resistor R11 and diode D1 which are connected in series across the power supply, to provide a reference voltage for amplifier A6. The output of amplifier A2 is connected via resistor R13 to the base electrode of a transistor T2. Transistor T2 has its collector electrode connected to the positive bus whilst its emitter electrode is connected via resistor R14 to the negative bus and via resistor R12 to the inverting input of amplifier A2. Hence amplifier A2 forms a non-inverting amplifier with an emitter follower connected to its output. This provides the necessary current for low resistance devices.

If the desired value of the cable RX is known, then the resistance of resistor R2 may be selected to give a suitable output from amplifier A2.

Similarly to Figs. 3 and 4, resistors R15 to R19 are connected in series across the power buses to create a voltage divider. The junctions of resistors R15, R16 and R17 are respectively connected to the inverting inputs of amplifiers A7 and A9, whilst the junction of resistors R17 and R18 is connected to the non-inverting input of amplifier A10. The non-inverting inputs of amplifiers A7 and A9 and the inverting input of amplifier A10 are each connected to the emitter electrode of transistor T2.

If the resistance of the cable RX is at its correct value then the output of amplifier A4 will be high as its reference level is set to a value less than the normal output level of amplifier A6. If, however, the resistance of the cable RX be less than its correct value by a given amount, the output of amplifier A6 will rise and cause amplifier A8 to produce a high output. If the resistance of the cable RX is unacceptably low then the output of amplifier A6 will be sufficiently high to produce a high output from amplifier A7. Alternatively, if the resistance of the cable RX is greater than its normal value then amplifier A5 will produce a high output.

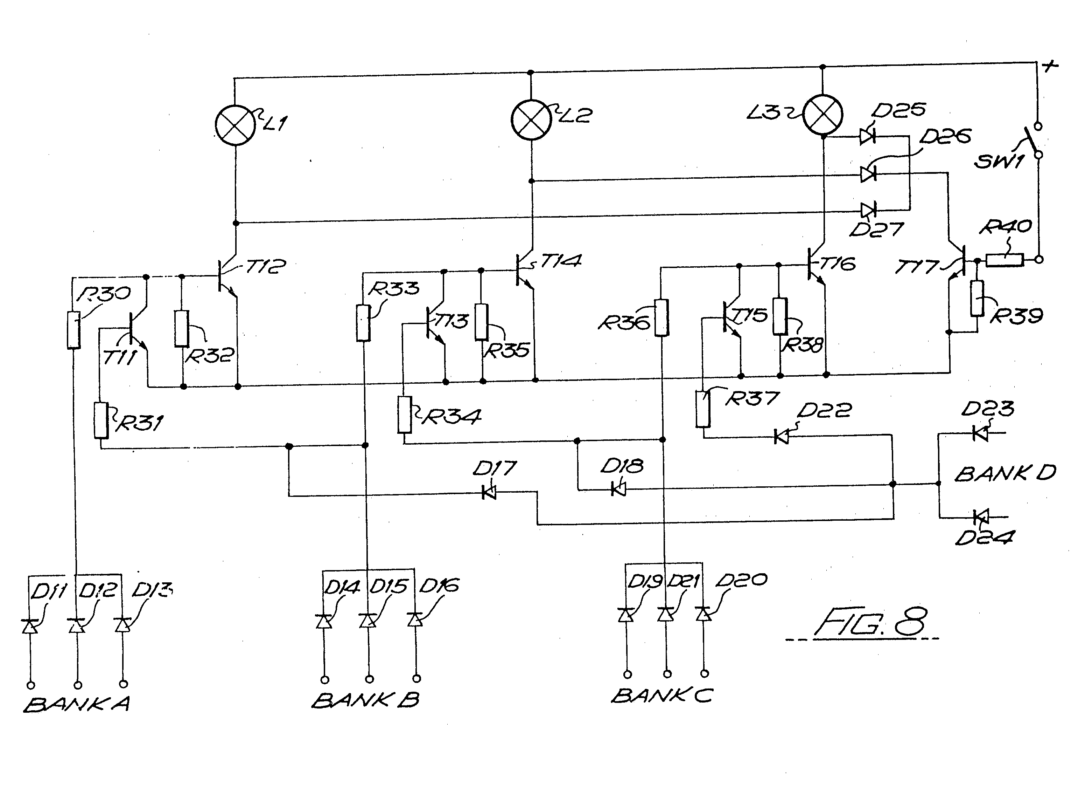

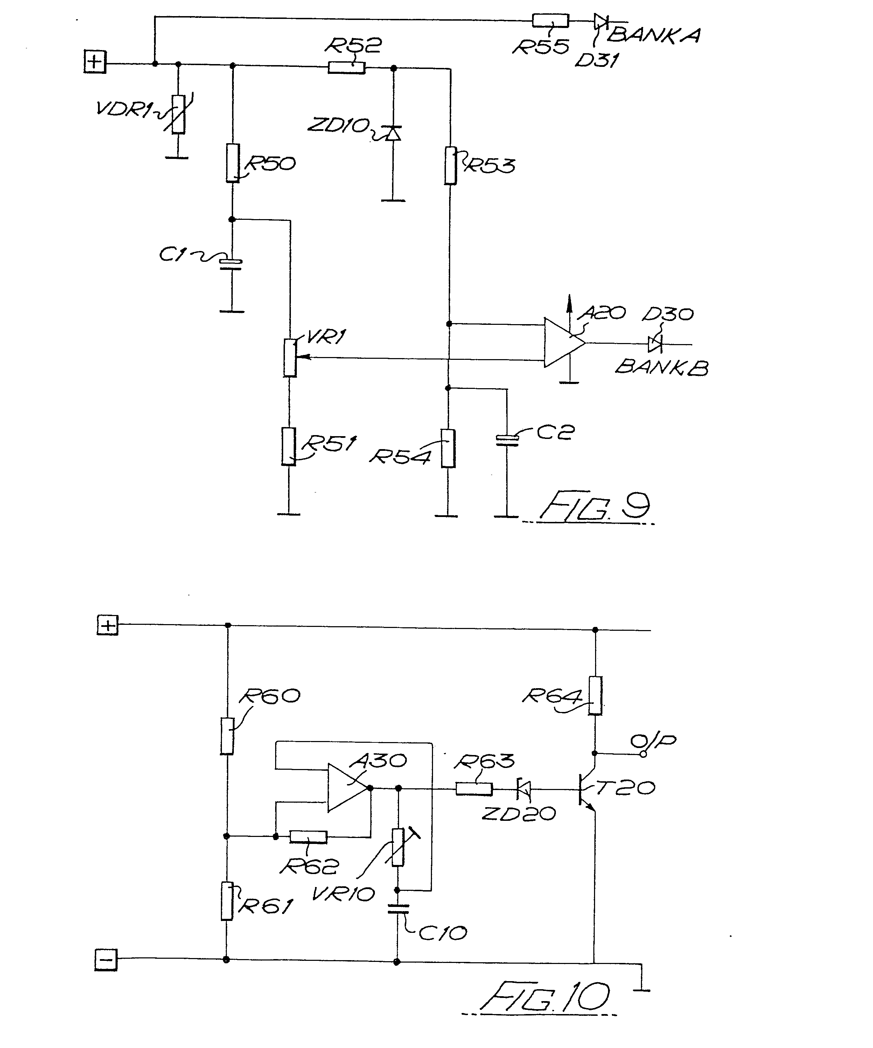

Figs. 6 and 7 illustrate circuits to show the current consumption of devices connected to either the positive or negative bus and where only one end of the device is accessible. The circuit of Fig. 7 is similar to that of Fig. 6 but inverted relative to the power buses and only Fig. 6 will be described here. The same reference numerals are used in these two figures.

A voltage divider is formed by connecting the device Rx in series with a resistor R20, the resistance of resistor R20 being very small relative to the resistance of the device Rx. Thus the current flowing through the voltage divider, and hence the potential across the resistor R20 is determined by the resistance of the device RX.

The voltage at the junction between the device RX and the resistor R20 is applied to the non-inverting input of an amplifier A11 via a resistor R21. The inverting input of the amplifier A11 is connected via resistor R22 and the output of the amplifier is connected to the inverting input by feedback resistor R23. Thus amplifier A11 forms a conventional non-inverting amplifier.

As in the circuit shown in Fig. 3, four resistors R24 to R27 are connected in series to form a voltage divider, the junctions of resistors R24 and R25 and R26 are connected to the inverting inputs of amplifiers A12 and A13 respectively and the junction of resistors R26 and R27 is connected to the non-inverting input of amplifier A14. The output of amplifier A11 is connected to the non-inverting inputs of amplifiers A12 and A13 and to the inverting input of amplifier A14.

The voltages produced by the voltage divider are such that, if the current through the device RX is of the correct order, the output from amplifier A11 will produce a high output from amplifier A13 and a low output from both amplifiers A12 and A14. If the current through the device RX is less than normal by a given amount, the voltage applied by the amplifier A11 to the inverting input of amplifier A14 will be less than the voltage applied to the non-inverting input and amplifier A14 will give a high output, to indicate a low resistance device Rx. Similarly, if the resistance of the device Rx is too high, the output of amplifier A11 will cause amplifier A12 to give a high output.

It is preferable that the outputs of the various circuits shown in Figs. 3 to 7 are connected to means providing a visual display of the condition of the circuit under test. A separate display may be provided for each circuit or, where the circuits are connected to the power supply as shown in Fig. 1, the same display may be used for all test circuits, since only one test circuit is operational at any one time.

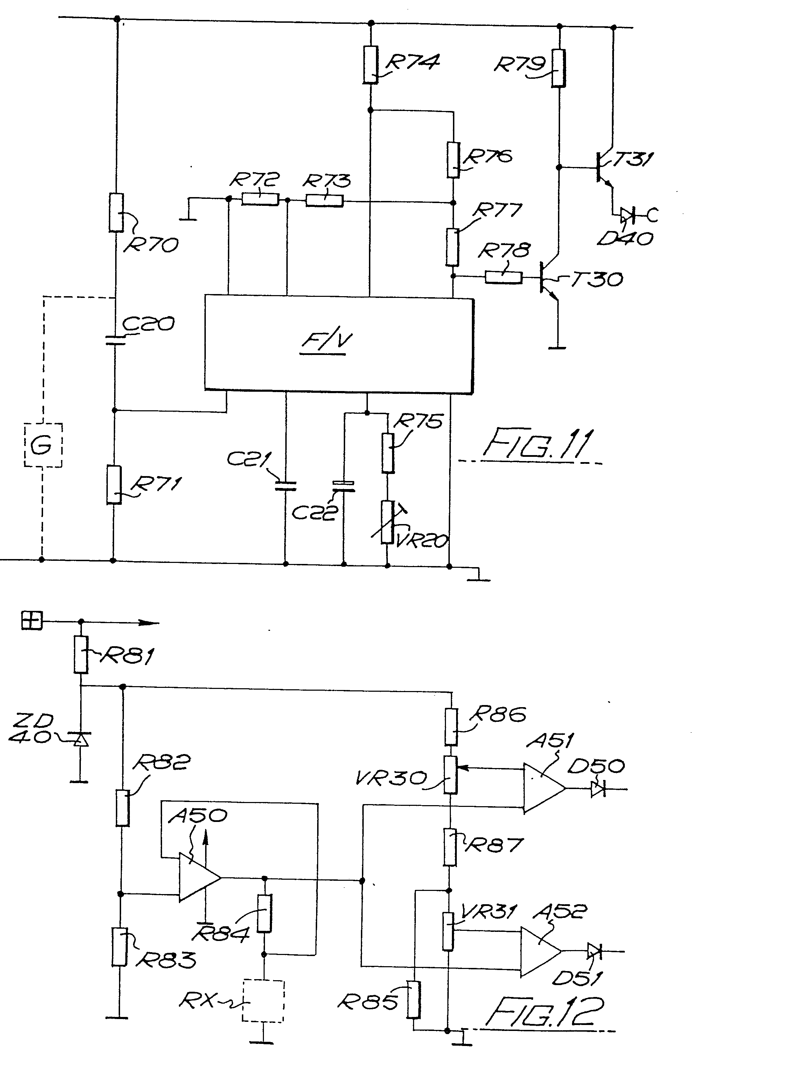

Fig. 8 shows an example of a circuit for a display device which may be connected to three test circuits, e.g. the circuits shown in Figs. 3, 5 and 6. The inputs of Bank A are connected to the corresponding outputs of Bank A amplifiers in the test circuits.

Suppose, for example, one of diodes D11 to D13 connected to a Bank A output becomes forward biased. Then a signal is applied via resistor R30 to the base electrode of transistor T12, which is normally biased off. Transistor T12 then becomes conducting and activates lamp L1.

If one of the diodes D14 to D16 connected to a Bank B output subsequently becomes forward biased, a signal is applied via resistor R33 to the base electrode of transistor T14 which becomes conducting to light lamp L2. Simultaneously a signal is applied via resistor R31 to the base electrode of a transistor T11, the collector and emitter electrodes of which are connected to the base and emitter electrodes of transistor T12. Thus an input to diodes D14 to D16 causes transistor T11 to become conducting, rendering transistor T12 non-conducting and turning lamp L1 off.

Similarly, if one of diodes D19 to D21 connected to a Bank C output becomes forward biased, a signal will be applied via resistor R36 to the base electrode

transistor T16 to light lamp L3 and simultaneously a signal will be applied via resistor R34 to the base electrode transistor T13 which will render transistor T14 non-conducting and extinguish lamp L2.

Diodes D23 and D24 are connected to Bank D outputs, which act so as to extinguish whichever of the lamps L1 to L3 is illuminated. If either of diodes D23 and D24 are rendered forwardly biased, signals are applied via diodes D17, D18 and D22 and resistors R31, R34 and R37 to the base electrodes of transistors T11, T13 and T15 respectively. Three transistors are respectively connected between the base and emitter electrodes of transistors T12, T14 and T16. Thus a signal from a Bank D output renders each of transistors T12, T14 and T16 non-conductive and all lights are extinguished.

The display circuit shown in Fig. 8 also has a lamp check device. By closing switch SW1 a transistor T17 is rendered conductive and currents flow through diodes D25 to D27, illuminating lamps L1 to L3.

In order to verify the alternator functions one need only check that the battery voltage rises when the alternator is running at a greater speed than tickover. This will not give an indication that the alternator is able to deliver its maximum current but will indicate that it is delivering a reasonable amount of current in order that the battery voltage may rise.

Fig. 9 shows a typical arrangement for voltage comparison. Two voltage divider circuits are formed by resistors R50, VR1 and R51 connected in series and by resistors R52 to R54 connected in series, respectively, between the positive bus and earth (or the negative bus). Resistor VR1 has a potentiometer contact which is connected to the non-inverting input of an amplifier A20. A variable resistor VDR1 is also connected between the positive bus and earth. Capacitors C1 and C2 are connected between earth and the junctions of resistors R50 and VR1 and resistors R53 and R54 respectively. The latter junction is also connected to the inverting input of amplifier A20. The potential across resistors R53 and R54 is determined by zener diode ZD10 connected between earth and the junction of resistors R52 and R53.

If the battery voltage is less than a specific level, then the potential at the non-inverting input of amplifier A20 will be less the potential at the non-inverting input (which is determined independently of battery voltage by zener diode ZD10 and resistors R53 and R54). Hence the output of amplifier A20 will be at a low level and diode D30, connected to the output of amplifier A20, will be reverse biased.

However, diode D31 connected via resistor R55 to the positive bus will be forward biased and will conduct.

Hence, if diode D31 is connected to one of the Bank A inputs of the display circuit shown in Fig. 8, or alternatively if diode D11 in Fig. 8 is connected directly to the positive bus of the circuit of Fig. 9, the light L1 will be illuminated.

If the battery voltage rises, then the potential at the non-inverting input of amplifier A20 will rise until the amplifier A20 gives a high output. If the amplifier A20 is connected by diode D30 to one of the Bank B inputs of the display circuit, then a high output from amplifier A20 will illuminate light L2 and extinguish light L1. This would then give a visual display that the alternator is working correctly.

In order to verify the correct operation of the tachometer a fixed frequency is applied to the tachometer head and the frequency is such that the head will, if working correctly, read a given figure in R.P.M. The method of obtaining the input to the head is shown in Fig. 10.

An oscillator circuit is formed by applying the voltage at the junction between resistors R60 and R61, connected in series between the positive and negative buses, to the non-inverting input of an amplifier A30. The output of amplifier A30 appears across variable resistor VR10 and capacitor C10 connected in series, is applied to the non-inverting input of amplifier A30 via feedback resistor R62 and fed to the base electrode of buffer transistor T20 via resistor R63 and zener diode ZD20. This circuit will oscillate at a fixed frequency, which may be adjusted by varying the resistance presented by variable resistor VR10. The collector electrode of the buffer transistor T20 is connected to the positive bus via resistor R64 and provides the required input conditions for the tachometer head.

An example of a circuit for testing a generator G is shown in Fig. 11. A series connection of a resistor R70, a capacitor C20 and another resistor R71 provide a load for the generator corresponding to that of normal use. When the generator is run, a frequency signal is generated which is fed to a frequency-to-voltage convertor A40. After conversion the output of the connector A40 is fed to the base electrode of a transistor T30 via resistor R78. At the frequency corresponding to that of correct operation, the voltage to transistor T1 renders it conductive, by causing transistor T31, the base electrode of which is connected electrode of transistor T30, to conduct. The output of transistor T31 indicates a satisfactory generation.

Fig. 12 shows a circuit for testing a temperature gauge probe or a fuel indicator. For such tests, the only factor that may be determined, without stipulating specific conditions, is whether the device is operating within its operating range or not, since the temperature may be at any value and the fuel tank may contain any amount of fuel.

A reference voltage is established across a zener diode ZD40 connected in series with resistor R81 between the positive bus and earth. The reference voltage is applied across two voltage dividers, the first consisting of resistors R82 and R83 connected in series with their junction connected to the non-inverting input of an amplifier A50, and the second consisting of resistors R86, VR30, R87 and VR31 connected in series, the variable resistors VR30 and VR31 having potientiometer contacts connected to the inverting inputs of amplifiers A51 and A52. Thus by adjusting the potientiometer contacts, the reference voltages applied to amplifiers A51 and A52 may be adjusted to suit the device under tests.

CLAIMS:

1.      An apparatus for testing electrical systems of a vehicle, characterised in that the apparatus comprises a plurality of test circuits (12, 14, 16) a plurality of connection leads each adapted to be connected to one electrical system of the vehicle and to one of the test circuits, switch means (10, 18, 20, 22) associated with said test circuits and acting on the test circuits (12, 14, 16) so that only one of the electrical systems of the vehicle may be tested at any one time via one of the connection leads by comparison of the property of that electrical system with a reference signal established in one of the test circuits (12, 14, 16).

2.      An apparatus according to claim 1, wherein the switch means includes a master switch (10) adapted selectively to energise one only of the test circuits (12, 14, 16) to establish said reference signal in it.

3.      An apparatus according to claim 1 or claim 2, wherein a plurality of connection leads are associated with each of the test circuits (12, 14, 16) and the switch means includes a selection switch (18, 20, 22) associated with each of the test circuits (12, 14, 16) each selection switch (18, 20, 22) being adapted to selectively connect one only of the leads to its associated test circuit (18, 20, 22).

4. An apparatus according to any one of the preceding claims, including a display associated with at least some of the test circuits (12, 14, 16), the display being provided with three indicators adapted to indicate the result of said comparison.

5. An apparatus according to any one of the preceding claims, wherein the test circuits are adapted to test battery feeds, battery returns, instruments and gauges, solenoids and inductive loads, motors or lighting of the vehicle.

6. An apparatus according to any one of the preceding claims, further including a control device (30) acting on the switch means (10, 18, 20, 22) so as to permit automatic selection of the system to be tested.

7. An apparatus according to claim 6, further including a memory (36) connected to the control device (30) and storing information relevant to at least some of the electrical systems under test, the control device (30) causing information about the selected system to be displayed on a display 34, together with the results of the test of that system.

8. The combination of a vehicle and an apparatus for testing electrical systems of the vehicle, the vehicle being provided with electrical sockets connected to respective testing points in the electrical systems of the vehicle, the apparatus comprising a plurality of electrical connectors each of which is connected to one of the sockets, a plurality of test circuits (12, 14, 16) at least two of said connectors being associated with each test circuit, a selection switch (18, 20, 22) associated with each test circuit (12, 14, 16) for selectively connecting one only of the connectors to its respective test circuit, and a master switch (10) for selecting one only of the test circuits (12, 14, 16) so that one only of said electrical systems may be tested at any one time by comparison of a property of that electrical system with a reference signal established in the selected test circuit.

9.       A method of testing electrical systems of a vehicle comprising:

        connecting a connection lead to each system to be tested, each of the connection leads being associated with a test circuit;

        testing one of the electrical systems by comparison of the property of that system with a reference signal established in a selected one of the test circuits, the testing being controlled by switch means such that only one of the electrical systems of the vehicle may be tested at any one time.

10.       A method according to claim 9, wherein each of the electrical systems to be tested is selected sequentially.

11.     A method according to claim 9, or claim 10, wherein a plurality of connection leads are associated with each test circuit and the testing includes selecting one of said test circuits and establishing a reference signal therein by operation of a master switch associated with all test circuits and connecting one only of the connector leads associated with the selected test circuit to that test circuit by operation of a selection switch associated with the selected test circuit.

1 / 8

FIG.1

0039122

FIG. 2

FIG. 3

FIG. 4

_FIG.5_

_FIG.6_

0039122

FIG. 7

FIG. 8

0039122

FIG. 9

FIG. 10

*FIG.11*

*FIG.12*